(19) Europäisches Patentamt
European Patent Office
Office européen des brevets

(11) **EP 3 293 880 B1**

(12) **FASCICULE DE BREVET EUROPEEN**

(45) Date de publication et mention
de la délivrance du brevet:
**24.02.2021 Bulletin 2021/08**

(21) Numéro de dépôt: **17189319.1**

(22) Date de dépôt: **05.09.2017**

(51) Int Cl.:
*H03F 1/56* (2006.01)          *H03F 3/60* (2006.01)
*H03F 3/19* (2006.01)          *H03F 7/00* (2006.01)

(54) **CIRCUIT D'ADAPTATION POUR AMPLIFICATEUR BAS BRUIT ET AMPLIFICATEUR BAS BRUIT COMPRENANT UN TEL CIRCUIT**

**ADAPTIONSSCHALTKREIS FÜR STÖRUNGSARMEN VERSTÄRKER, UND STÖRUNGSARMER VERSTÄRKER, DER EINEN SOLCHEN SCHALTKREIS UMFASST**

**ADAPTATION CIRCUIT FOR LOW NOISE AMPLIFIER AND LOW NOISE AMPLIFIER INCLUDING SUCH A CIRCUIT**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.09.2016 FR 1658429**

(43) Date de publication de la demande:
**14.03.2018 Bulletin 2018/11**

(73) Titulaire: **Commissariat à l'Energie Atomique et aux Energies Alternatives**
**75015 Paris (FR)**

(72) Inventeurs:
• **HOFHEINZ, Max**
**38000 GRENOBLE (FR)**
• **JEBARI, Salha**
**38100 GRENOBLE (FR)**

(74) Mandataire: **Cabinet Camus Lebkiri**
**25 rue de Maubeuge**
**75009 Paris (FR)**

(56) Documents cités:
**WO-A1-2012/123642     US-A1- 2014 218 105**

• **VESTERINEN V ET AL: "Tunable Impedance Matching for Josephson Junction Reflection Amplifier", IEEE TRANSACTIONS ON APPLIED SUPERCONDUCTIVITY, IEEE SERVICE CENTER, LOS ALAMITOS, CA, US, vol. 23, no. 3, 1 juin 2013 (2013-06-01), page 1500104, XP011513773, ISSN: 1051-8223, DOI: 10.1109/TASC.2012.2227653**
• **PASI LÄHTEENMÄKI ET AL: "Josephson junction microwave amplifier in self-organized noise compression mode", SCIENTIFIC REPORTS, vol. 2, 20 février 2012 (2012-02-20), XP055371182, DOI: 10.1038/srep00276**
• **VIJAY R ET AL: "Invited Review Article: The Josephson bifurcation amplifier", REVIEW OF SCIENTIFIC INSTRUMENTS, AIP, MELVILLE, NY, US, vol. 80, no. 11, 17 novembre 2009 (2009-11-17), pages 111101-111101, XP012127956, ISSN: 0034-6748, DOI: 10.1063/1.3224703**
• **Y. TAUR ET AL: "Parametric amplification and oscillation at 36 GHz using a point-contact Josephson junction", JOURNAL OF APPLIED PHYSICS, vol. 48, no. 3, 1 mars 1977 (1977-03-01), pages 1321-1326, XP055371156, US ISSN: 0021-8979, DOI: 10.1063/1.323777**

**Description**

**DOMAINE TECHNIQUE DE L'INVENTION**

Le domaine technique de l'invention est celui des amplificateurs hautes fréquences. La présente invention concerne un circuit d'adaptation pour un amplificateur bas bruit. L'invention concerne également un amplificateur bas bruit comprenant un tel circuit d'adaptation et en particulier un amplificateur bas bruit à jonction Josephson.

**ARRIERE-PLAN TECHNOLOGIQUE DE L'INVENTION**

Dans le cadre de la recherche fondamentale ou de la radioastronomie, il est souvent nécessaire d'avoir recours à des amplificateurs dit très faible bruit, c'est-à-dire des amplificateurs dont le bruit est aussi proche que possible de la limite théorique imposée par la mécanique quantique, et ce, pour des fréquences allant du MHz au THz. Il est possible de distinguer deux types d'amplificateurs : les amplificateurs préservant la phase et les amplificateurs sensibles à la phase. Les amplificateurs sensibles à la phase ne sont pas soumis à la limitation théorique mais ils sont difficiles à utiliser car la phase du signal à amplifier doit parfaitement correspondre à la quadrature amplifiée. Les amplificateurs préservant la phase sont soumis à la limite quantique mais n'imposent en revanche aucune condition quant à la phase du signal à amplifier.

Dans le domaine de l'amplification haute fréquence et très haute fréquence il est connu d'utiliser une amplification par réflexion. Cette dernière est obtenue par exemple à l'aide d'une ligne de transmission d'impédance $Z_0$ terminée par une impédance $Z_L(f)$ où f est la fréquence du signal. Le coefficient de réflexion en tension d'une telle structure est donnée par $G(f) = \frac{(Z_L(f) - Z_0)}{(Z_L(f) + Z_0)}$. Si l'on parvient à obtenir une impédance $Z_L(f)$ négative dont la valeur absolue est proche de $Z_0$, le coefficient G(f) de réflexion diverge et le signal réfléchi est donc amplifié. Bien sûr, cette condition n'est remplie que pour une bande de fréquence donnée qui correspond alors à la bande passante de l'amplificateur.

Dans le domaine de l'amplification, il est aussi connu d'utiliser des transistors semiconducteurs travaillant à des températures cryogéniques. Les transistors sont polarisés en tension ce qui rend l'utilisation de ce type d'amplificateurs très facile à mettre en œuvre. En revanche leur niveau de bruit, même à température cryogénique, reste encore élevé : de l'ordre de 10 photons dans le meilleur des cas, soit 20 fois la limite quantique. Pour limiter le bruit au maximum, il a été proposé d'utiliser un amplificateur paramétrique dans lequel l'impédance négative est obtenue par exemple par l'intermédiaire de quatre jonctions Josephson. Le circuit de l'amplificateur possède un premier mode à la fréquence signal $f_s$ et un deuxième mode à la fréquence idler $f_i$. Les paramètres du circuit sont modifiés à l'aide de la pompe de fréquence $f_p$. Cet amplificateur permet d'obtenir une bande passante de quelques MHz avec un bruit proche de la limite quantique mais nécessite la génération d'une pompe, ce qui le rend complexe à mettre en œuvre.

Une autre manière de comprendre cette amplification paramétrique est d'envisager cette dernière en termes de photons, chaque photon étant associé à une énergie. Par exemple, un premier photon d'énergie $E_1$ peut être converti en un deuxième photon d'énergie $E_2$ et un troisième photon d'énergie $E_3$ si la relation entre ces trois énergies est telle que $E_1 = E_2 + E_3$ (il s'agit d'une condition nécessaire mais pas suffisante). Sachant qu'il est possible d'associer à chaque énergie une fréquence, cette égalité devient $f_1 = f_2 + f_3$. Si l'on cherche à amplifier un signal de fréquence $f_2$, il est donc possible d'avoir recours à un signal de fréquence $f_1$ sous réserve qu'un mode, c'est-à-dire une résonnance du système, à une fréquence $f_3$ soit également présent. Dans la suite, la fréquence $f_1$ est appelée fréquence pompe $f_p$, la fréquence $f_2$ est appelée fréquence signal $f_s$ et la fréquence $f_3$ est appelée fréquence idler $f_i$. Il est possible d'obtenir une amplification d'un signal de fréquence $f_s$ par la génération d'autres photons de signal de fréquence $f_s$ à partir des photons de pompe de fréquence $f_p$, cette génération entrainant également la génération de photons idler de fréquence $f_i$. Afin que ce processus d'amplification ait lieu, il est en outre nécessaire, en plus de la condition de conservation de l'énergie, que les différentes fréquences soient couplées entre elles. Un tel couplage est réalisé à l'aide d'une impédance non linéaire.

Alternativement, il a été proposé d'utiliser un amplificateur dans lequel l'impédance négative est obtenue à l'aide d'une jonction Josephson polarisée en tension. Cette polarisation en tension permet de s'affranchir de la pompe et contribue à la simplification du dispositif. En effet, une fois la jonction polarisée, les paires de Cooper responsables du courant supraconducteur dotées d'une énergie proportionnelle à la tension appliquée à la jonction vont devoir relaxer, c'est-à-dire revenir à leur état énergétique fondamental. Or, le seul mécanisme permettant cette relaxation conduit à l'émission d'un ou plusieurs photons dont l'énergie est liée à la tension de polarisation appliquée. Autrement dit, la tension appliquée permet de générer des photons de la même manière que la fréquence pompe de l'amplificateur paramétrique, la fréquence de ces photons étant ici fonction de la tension appliquée à la jonction.

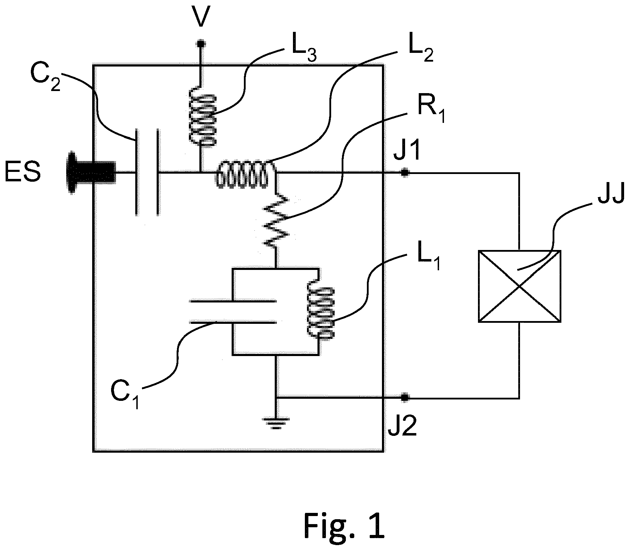

De plus, l'amplification peut être obtenue, dans le mode de réalisation le plus simple, avec une seule jonction Josephson. Un tel dispositif est illustré à la figure 1 et se compose d'un circuit d'adaptation comprenant un premier port de connexion J1 et un deuxième port de connexion J2, ces deux ports étant connectés à une jonction Josephson JJ.

Afin de polariser la jonction Josephson JJ, une source de tension V est connectée à l'aide d'une connexion en T constituée par l'inductance $L_3$ et la capacité $C_2$. Le circuit d'adaptation comprend également une résistance $R_1$ en série avec une capacité $C_1$ et une inductance $L_1$ en parallèle l'une de l'autre. Ce circuit d'adaptation permet une polarisation de la jonction Josephson JJ de sorte que cette dernière présente une impédance différentielle négative sur une large plage de tension tout en maintenant une impédance globale, c'est-à-dire l'impédance de la jonction Josephson JJ et du circuit d'adaptation, positive.

Dans ce dispositif, il est possible de distinguer deux situations. Pour les hautes et basses fréquences, la jonction Josephson est court-circuitée par le circuit d'adaptation. La partie réelle du coefficient de réflexion est alors égale à

$Re(G(f)) = \dfrac{(R_1 - Z_0)}{(R_1 + Z_0)}$ avec $R_1$ la résistance du circuit d'adaptation. $R_1$ étant de l'ordre de quelques ohms contre plusieurs dizaines de ohms pour $Z_0$, la partie réelle du coefficient de réflexion devient $Re(G(f)) \sim -1$ et il n'y a donc aucune amplification du signal mais seulement un déphasage de $\pi$. En revanche, à la fréquence du signal $f_s$, l'impédance du circuit d'adaptation est élevée et l'impédance de la jonction Josephson JJ devient donc « visible » de sorte que l'impédance mesurée au niveau du port d'entrée/sortie est telle que $Z_L < 0$ et $|Z_L| \geq Z_0$, l'amplitude de la réflexion est donc $Re(G(f_s)) > 1$ et il y a donc amplification du signal. En outre, plus $Z_L$ se rapproche de $-Z_0$, plus l'amplification est importante. Dans le circuit précédemment évoqué, le circuit $L_2 C_2$ permet de réaliser une adaptation d'impédance entre l'impédance de la jonction Josephson JJ à la fréquence $f_s$ et le port d'entrée du circuit. L'inductance $L_3$ permet quant à elle d'isoler la partie haute fréquence du circuit de la partie DC. Cependant, bien que ce dispositif améliore le bruit comparativement à un amplificateur utilisant des transistors, le niveau de bruit demeure supérieur au niveau de bruit obtenu avec un amplificateur paramétrique. La demande de brevet international publiée WO 2012/123642 divulgue un circuit d'adaptation d'impédance destiné à être connecté à une impédance non-linéaire comprenant un supraconducteur. L'article de Verterinen et al. Intitulé : « Tunable Impedance Matching for Josephson Junction Reflection Amplifier », IEEE TRANSACTION ON APPLIED SUPERCONDUCTIVITY, IEEE SERVICE CENTER, LOS ALAMITOS, CA, US, vol. 23, no. 3, 1 juin 2013 divulgue un circuit d'adaptation d'impédance ajustable pour un amplificateur à jonction Josephson polarisée en tension. L'article de Pasi Lähteemäki et al. Intitulé : « Josephson junction microwave amplifier in self-organized noise compression mode », SCIENTIFIC REPORT, vol. 2, 20 février 2012 divulgue également un circuit d'adaptation d'impédance pour un amplificateur à jonction Josephson polarisée en tension.

Il existe donc un besoin de fabriquer un amplificateur permettant de maintenir le niveau de bruit similaire à celui d'un amplificateur paramétrique tout en présentant la simplicité d'un amplificateur à jonction Josephson polarisée en tension.

## RESUME DE L'INVENTION

L'invention offre une solution aux problèmes évoqués précédemment en proposant un circuit d'adaptation permettant de diminuer le bruit généré par un amplificateur à jonction Josephson polarisée en tension. Elle propose également un amplificateur utilisant un tel circuit.

Un premier aspect de l'invention concerne un circuit d'adaptation d'impédance destiné à être connecté à une impédance non-linéaire comprenant un supraconducteur, ledit circuit comportant un premier terminal dit premier port de connexion destiné à être connecté à une première borne de l'impédance non-linéaire, un deuxième terminal dit deuxième port de connexion destiné à être connecté à une deuxième borne de l'impédance non-linéaire, un troisième terminal dit terminal d'entrée/sortie destiné à recevoir le signal à amplifier avec un gain en puissance G et une bande passante BW et un quatrième terminal dit terminal d'alimentation destiné à être connecté à une source de polarisation et configuré pour qu'une tension V puissent être appliquée entre le premier port de connexion et le deuxième port de connexion.

Le circuit d'adaptation selon l'invention comporte une pluralité de composants électriques passifs configurés de sorte que l'impédance $Z(f)$ entre le premier port de connexion et le deuxième port de connexion pour un signal de fréquence f a une partie réelle $Re(Z(f))$ telle que :

- $Re(Z(f_s)) > 0$ avec $f_s$ une première fréquence dite fréquence signal ;
- $Re(Z(f_i)) > 0$ avec $f_i$ une deuxième fréquence dite fréquence idler ;

- $Re(Z(0)) < \dfrac{h}{4e^2} \dfrac{f_p}{G.BW}$ avec $f_p$ une troisième fréquence dite fréquence pompe ;

-

$$Re(Z(f_p + f_s)) < \frac{f_p + f_s}{f_i} Re(Z(f_i)) ;$$

la fréquence de pompe étant choisie de sorte que $nf_p = f_s + f_i$ avec n un entier appartenant à [1, +∞] et la fréquence idler étant choisie de sorte que $f_i > \dfrac{k_B T}{h}$ avec T la température du circuit, $k_B$ la constante de Boltzmann et h la constante de Planck.

On entend par $Z(f_X)$ la valeur de l'impédance pour une fréquence appartenant à une plage de fréquences de largeur définie et centrée sur la fréquence $f_X$. Sauf précision contraire, lorsqu'il est fait mention d'une fréquence $f_X$ cette dernière doit être comprise comme une fréquence f appartenant à un intervalle [$f_X - \Delta f$, $f_X + \Delta f$] avec $\Delta f < 0.5 f_s$ voire $\Delta f < 0.1 f_s$. La source de polarisation peut notamment être choisie parmi une source de tension, une source de courant ou bien encore une impédance finie.

De manière générale, la probabilité qu'a une paire de Cooper de relaxer en générant un photon à la fréquence f, est approximativement proportionnelle à l'impédance vue par l'élément supraconducteur à ladite fréquence f. En particulier, une paire de Cooper a une plus grande probabilité de relaxer en émettant un photon à la fréquence f lorsqu'un mode de résonance de l'impédance Z(f) vu par l'impédance non linéaire est présent à cette fréquence. Les inventeurs, tirant parti de cette propriété, ont identifié les conditions concernant cette impédance qui limitent le bruit généré.

Les conditions $Re(Z(f_s)) > 0$ et $Re(Z(f_i)) > 0$ permettent de s'assurer de l'amplification du signal à la fréquence de signal $f_s$. En effet l'impédance étant non nulle à ces fréquences, des photons peuvent être générés auxdites fréquences.

La condition $Re(Z(0)) < \dfrac{h}{4e^2} \dfrac{f_p}{G.BW}$ permet quant à elle de stabiliser le point de fonctionnement.

De plus, la condition $Re\left(Z\left(f_p + f_s\right)\right) < \dfrac{f_p + f_s}{f_i} Re(Z(f_i))$ permet d'éviter que des photons à la fréquence signal $f_s$ soient convertis, lors de la relaxation des paires de Cooper, en photons à la fréquence pompe plus la fréquence signal $f_p + f_s$, ce qui conduirait à la diminution du rapport signal sur bruit, une partie des photons du signal étant perdus lors de cette conversion. En effet, il est également possible que des photons du signal de fréquence signal $f_s$ s'associent avec des photons de la pompe de fréquence pompe $f_p$ pour créer des photons de fréquence pompe plus fréquence signal $f_p + f_s$. La condition évoquée précédemment permet de s'assurer que la probabilité d'un tel processus est faible comparativement au processus donnant lieu à l'amplification du signal. On notera que cette condition ne s'applique pas ici à la fréquence signal $f_p - f_s$. Ainsi, les fréquences signal $f_p + f_s$ et $f_p - f_s$ sont traitées différemment contrairement à ce qui est fait dans l'état de l'art antérieur.

En outre, la condition $f_i > \dfrac{k_B T}{h}$ permet de s'assurer que la fréquence idler $f_i$ ne se peuple pas de photons thermiques. La température dont il est question ici est la température de l'élément dans lequel se dissipent les photons de la fréquence idler $f_i$, en général la température électronique dudit élément. En effet, de la même manière que l'amplificateur amplifie le signal de fréquence signal $f_s$ en produisant des photons idler, le processus symétrique est également possible. Le signal associé aux photons thermiques pourrait donc se voir amplifié entrainant la génération de photons signal et donc la génération de bruit à la fréquence signal $f_s$. La condition évoquée précédemment permet de limiter le bruit provenant de photons thermiques à la fréquence idler $f_i$.

Enfin, la condition $nf_p = f_s + f_i$ permet de s'assurer que la condition concernant la conservation de l'énergie évoquée précédemment est remplie.

Autrement dit, grâce au circuit d'adaptation selon l'invention, le bruit inutile n'est pas ramené depuis les fréquences élevées vers la fréquence d'amplification. De plus, le signal utile n'est pas perdu vers d'autres fréquences.

Outre les caractéristiques qui viennent d'être évoquées dans le paragraphe précédent, le circuit d'adaptation d'impédance selon un premier aspect de l'invention peut présenter une ou plusieurs caractéristiques complémentaires parmi les suivantes, considérées individuellement ou selon toutes les combinaisons techniquement possibles.

Avantageusement, $Re(Z\left(f_p + f_s\right)) < \dfrac{Re(Z(f_i))}{10}$. Ainsi, la conversion des photons à la fréquence signal $f_s$ en photons à la fréquence pompe plus la fréquence signal $f_p + f_s$ est encore d'avantage réduite.

Avantageusement, $Re(Z(0)) < \dfrac{h}{4e^2} \dfrac{1}{10G}$ ce qui améliore encore la stabilité du point de fonctionnement.

Avantageusement, $Re\left(Z\left(f_p\right)\right) < \dfrac{4e^2}{h} BW \dfrac{f_p}{f_s.f_i} Re(Z(f_s)) Re(Z(f_i))$. Ainsi la probabilité de générer, à partir des paires de Cooper, un photon à la fréquence pompe $f_p$ est inférieure à la probabilité de générer à partir des paires de Copper un photon à la fréquence signal $f_s$ et un photon à la fréquence ider $f_i$. Autrement dit, l'énergie des paires de Cooper est préférentiellement évacuée par l'émission de photons de fréquence $f_s$ et $f_i$, ce qui permet d'assurer une conversion optimale des paires de Cooper en photons à la fréquence signal $f_s$ (et $f_i$) plutôt qu'à la fréquence pompe $f_p$.

Avantageusement, le terminal d'entrée/sortie est destiné à être connecté à une impédance de valeur $Z_0$ et

$$\text{Re}\big(Z(f_s)\big) < 2 \frac{|Z_{\text{trans}}(f_s)|^2}{Z_0}$$ avec $Z_{\text{trans}}(f_s)$ la tension mesurée au niveau du terminal d'entrée/sortie lorsqu'un courant unitaire de fréquence $f_s$ est appliqué entre le premier port de connexion et le deuxième port de connexion (autrement dit lorsqu'un courant unitaire alternatif de fréquence $f_s$ circule entre le premier port de connexion et le deuxième port de connexion). De manière encore plus avantageuse $\text{Re}\big(Z(f_s)\big) < 1{,}1 \frac{|Z_{\text{trans}}(f_s)|^2}{Z_0}$. Cette condition permet de s'assurer que les photons amplifiés et à amplifier ne sont pas dissipés dans le circuit mais bien envoyés vers le terminal d'entrée/sortie.

Avantageusement, $\text{Re}\left(Z\big(f_p + f_i\big)\right) < \frac{f_p + f_i}{f_s} \text{Re}(Z(f_s))$. Encore plus avantageusement, $\text{Re}\left(Z\big(f_p + f_i\big)\right) < \frac{\text{Re}(Z(f_s))}{10}$. Cette condition permet de s'assurer que des photons à la fréquence idler $f_i$ ne soient pas convertis, en association avec des photons à la fréquence pompe $f_p$, en des photons de fréquence pompe plus fréquence idler $f_p + f_i$, ce qui aurait pour conséquence de diminuer l'amplification, les photons pompe mis en jeu dans ce processus ne pouvant plus servir à l'amplification du signal.

Avantageusement, $f_i > 4 \frac{k_B T}{h}$. Les photons obéissant à la distribution des Bose-Einstein, cette condition permet de s'assurer que quasiment aucun photon thermique ne se trouve à la fréquence idler $f_i$ dans l'élément dissipant les photons à la fréquence idler $f_i$.

Avantageusement, n = 1 ou, autrement dit, $f_p = \frac{2eV}{h} = f_s + f_i$. Ainsi, la génération d'un photon signal ne nécessite qu'une seule paire de Cooper ce qui rend le processus plus probable et donc l'amplification plus efficace.

Avantageusement, $\max\big\{\text{Re}\big(Z(f_s)\big), \text{Re}\big(Z(f_i)\big)\big\} < \frac{h}{4e^2}$ voire $\max\{\text{Re}(Z(f_s)), \text{Re}(Z(f_i))\} < 100\Omega$ voire $\max\{\text{Re}(Z(f_s)), \text{Re}(Z(f_i))\} < 10\Omega$. Cette condition permet d'améliorer la dynamique de l'amplificateur dans lequel le circuit d'adaptation est destiné à être utilisé.

Avantageusement, l'impédance Z(f) présente un maximum local en $f_s$ et/ou $f_i$. Ainsi, le circuit d'adaptation présente des modes de résonance à la fréquence signal $f_s$ et/ou à la fréquence idler $f_i$ ce qui permet de garantir qu'à ces fréquences un photon a une forte probabilité d'être généré lors de la relaxation des paires de Cooper.

Avantageusement, $\frac{\text{Re}(Z(f_s)).\text{Re}(Z(f_i))}{f_s.f_i} > \frac{\text{Re}(Z(f)).\text{Re}(Z(f-f_p))}{f.(f_p-f)}$ pour toute fréquence f différente de 0, $f_s$, $f_i$ et $f_p$. Cette condition permet de s'assurer que l'amplification amplifie seulement dans la bande passante c'est-à-dire que l'amplificateur utilisant un circuit d'adaptation selon l'invention peut avoir un fort gain à $f_s$ sans devenir instable aux autres fréquences f.

Avantageusement, l'impédance Z(f) présente un minimum local en $f_p$ et/ou $f_p + f_i$ et/ou $f_p + f_s$. Ainsi, le circuit présente des anti-résonnances à la fréquence pompe $f_p$, à la fréquence pompe plus la fréquence idler $f_p + f_i$ et à la fréquence pompe plus la fréquence signal $f_p + f_s$ ce qui permet de garantir qu'à ces fréquences un photon a une faible probabilité d'être généré lors de la relaxation des paires de Cooper.

Avantageusement, la pluralité de composants électriques passifs comporte :

- un premier segment de guide d'onde dont une première extrémité est connectée au terminal d'alimentation par l'intermédiaire d'une inductance et au terminal d'entrée/sortie par l'intermédiaire d'une première capacité et une deuxième extrémité est connectée au premier port de connexion ;
- un deuxième segment de guide d'onde dont une première extrémité est connectée à la masse par l'intermédiaire d'une deuxième capacité et une deuxième extrémité est connectée au premier port de connexion ;
- un troisième segment de guide d'onde dont une première extrémité est connectée à une impédance infinie et une deuxième extrémité est connectée au premier port de connexion ;

En outre, le deuxième port de connexion est connecté à la masse. Ainsi, les propriétés électriques sont obtenues à l'aide de guides d'onde. L'impédance et la fréquence de résonance de ces derniers étant facile à contrôler par l'intermédiaire de leurs dimensions, leur utilisation est très avantageuse.

Avantageusement, la pluralité de composants électriques passifs comporte :

- un premier segment de guide d'onde dont une première extrémité est connectée au terminal d'entrée/sortie ;
- un deuxième segment de guide d'onde dont une première extrémité est connectée à une deuxième extrémité du premier segment de guide d'onde et dont une deuxième extrémité est connectée à une impédance infinie ;
- un troisième segment de guide d'onde dont une première extrémité est connectée à la deuxième extrémité du premier segment de guide d'onde et dont une deuxième extrémité est connectée à une impédance infinie ;
- un quatrième segment de guide d'onde dont une première extrémité est connectée à la masse par l'intermédiaire d'une capacité et au terminal d'alimentation et dont une deuxième extrémité est connectée au premier port de connexion ;
- un cinquième segment de guide d'onde dont une première extrémité est connectée à une impédance infinie et dont une deuxième extrémité est connecté au premier port de connexion.

En outre, le deuxième port de connexion est connecté à la masse, le deuxième segment de guide d'onde est en outre couplé de manière capacitive au quatrième segment de guide d'onde et le troisième segment de guide d'onde est couplé de manière capacitive au cinquième segment de guide d'onde de sorte à former un coupleur.

Avantageusement, la pluralité de composants électriques passifs comporte :

- une inductance $L_1$ dont une première borne est connectée au terminal d'alimentation et dont une deuxième borne est connectée à la masse par l'intermédiaire d'une première capacité, au terminal d'entrée/sortie par l'intermédiaire d'une quatrième capacité et au premier port de connexion ;
- un premier segment de guide d'onde dont une première extrémité est connectée à une impédance infinie et dont une deuxième extrémité est connectée à la masse par l'intermédiaire d'une résistance ;
- un deuxième segment de guide d'onde dont une première extrémité est à une impédance infinie et dont une deuxième extrémité est connectée au deuxième port de connexion par l'intermédiaire d'une deuxième capacité ;
- un troisième segment de guide d'onde dont une extrémité est connectée à une impédance infinie et dont une deuxième extrémité est connectée au deuxième port de connexion par l'intermédiaire d'une troisième capacité ;
- un quatrième segment de guide d'onde dont une première extrémité est connectée à la masse et dont une deuxième extrémité est connectée au deuxième port de connexion.

En outre, le premier segment de guide d'onde est couplé de manière capacitive au quatrième guide d'onde.

Avantageusement, au moins un segment de guide d'onde est réalisé dans un matériau supraconducteur afin de diminuer la dissipation, et donc le bruit thermique, au sein du circuit d'adaptation.

Un deuxième aspect de l'invention concerne un amplificateur à réflexion comportant un circuit d'adaptation d'impédance selon un premier aspect de l'invention, une source de polarisation connectée au terminal d'alimentation, une impédance non linéaire comprenant un supraconducteur, ladite impédance non-linéaire comportant une premier borne et une deuxième borne, la première borne de l'impédance étant connectée au premier port de connexion du circuit d'adaptation, la deuxième borne de l'impédance étant connectée au deuxième port de connexion du circuit d'adaptation. De plus, la tension V appliquée entre le premier terminal de connexion et le deuxième terminal de connexion au moyen de la source de polarisation est choisie de sorte que $f_p = \dfrac{2eV}{h}$ avec 2e la charge électrique d'une paire de Cooper et h la constante de Planck.

Avantageusement, dans l'amplificateur selon un deuxième aspect de l'invention, le matériau supraconducteur de l'impédance non-linéaire est choisi de sorte que $f_s < \dfrac{2\Delta}{h}$ avec $\Delta$ le gap supraconducteur du supraconducteur. Ainsi, en imposant $f_s < \dfrac{2\Delta}{h}$, on s'assure que la dissipation du supraconducteur est faible à $f_s$.

Avantageusement, $f_p < \dfrac{4\Delta}{h}$, ceci afin de s'assurer que la tension appliquée à l'impédance non linéaire afin de faire circuler les paires de Cooper à travers l'impédance non linéaire n'excède pas le gap supraconducteur $2\Delta$ et que donc le transport n'implique pas de quasi-particules au niveau du supraconducteur.

En outre, ce deuxième aspect de l'invention permet d'obtenir des performances proches ou équivalentes à celle d'un amplificateur paramétrique, mais avec une alimentation DC au lieu d'une alimentation par un signal micro-ondes. Cela rend l'utilisation d'un tel amplificateur bien plus simple et moins onéreuse, surtout dans un environnement cryogénique. Un tel avantage devient notamment important au-dessus de 10 GHz.

De plus, le fait de travailler avec une jonction polarisée en tension permet de travailler à plus haute fréquence. En effet, dans le cas d'un amplificateur paramétrique, la jonction est dans l'état supraconducteur où elle a un comportement inductif. Cette inductance, ensemble avec la capacité de la jonction, détermine la fréquence plasma de la jonction a une valeur environ égale à $\frac{\Delta}{2h}$, soit de l'ordre de 30 GHz pour l'Aluminium (Al), 300 GHz pour le nitrure de niobium (NbN) et la fréquence du signal micro-ondes utilisé (et donc la fréquence de travail de l'amplificateur) est limitée par cette fréquence plasma. Dans le cas d'un amplificateur selon l'invention, la jonction polarisée en tension n'a pas d'inductance et cet amplificateur peut donc travailler jusqu'à des fréquences de $\frac{\Delta}{2h}$, soit environ 100 GHz pour l'Aluminium et 1 THz pour le nitrure de niobium. Pour un même matériau il sera donc possible d'optimiser un amplificateur selon l'invention pour des fréquences de travail environ 3 fois plus élevées que celles accessibles par un amplificateur paramétrique classique à base de jonctions Josephson dans l'état supraconducteur.

Par ailleurs, comme cela a été présenté précédemment, il est préférable d'avoir une fréquence idler $f_i$ telle que $f_i > \frac{k_B T}{h}$ (voire $f_i > 4\frac{k_B T}{h}$) afin de limiter au maximum le bruit thermique de l'amplificateur. La facilité d'augmenter la tension d'alimentation permet d'augmenter aisément la fréquence idler $f_i$ ce qui rend les exigences de refroidissement moins contraignantes. Un amplificateur selon l'invention fonctionnant à 4K (c'est-à-dire proche de la température de l'Hélium liquide) avec une fréquence idler $f_i$ à 1 THz peut ainsi être très proche de la limite quantique même si la fréquence signal $f_s$ est bien plus basse. Un amplificateur paramétrique typique doit au contraire être refroidi à des températures inférieures 100 mK ce qui nécessitent un réfrigérateur à dilution.

Enfin, le gain de l'amplificateur selon l'invention augmente avec le courant critique de la jonction (ou du SQUID), tandis que dans le cas des amplificateurs paramétriques il diminue. Ceci peut faciliter l'optimisation de l'amplificateur pour avoir à la fois un fort gain pour une large bande passante et une large étendue dynamique (point de compression élevé) qui nécessite des courants critiques élevés.

Outre les caractéristiques qui viennent d'être évoquées dans le paragraphe précédent, l'amplificateur à réflexion selon un deuxième aspect de l'invention peut présenter une ou plusieurs caractéristiques complémentaires parmi les suivantes, considérées individuellement ou selon toutes les combinaisons techniquement possibles.

Avantageusement, l'impédance non-linéaire comprend une jonction Josephson. La jonction Josephson présente notamment l'avantage d'être un élément non linéaire avec des caractéristiques physiques et un comportement bien compris donc plus facile à mettre en œuvre.

Avantageusement, la jonction Josephson est de type SIS (Supraconducteur/Isolant/Supraconducteur). Une jonction de type SIS présente l'avantage d'être un élément non linéaire non dissipatif ce qui évite de créer des processus de conversion parasites.

Avantageusement, l'impédance non-linéaire supraconductrice comprend un SQUID. Ainsi, il est possible de moduler le gain de l'amplificateur à l'aide d'un champ magnétique.

Avantageusement, la bande passant BW de l'amplificateur est choisie de sorte que $BW > \frac{2e}{h}\Delta V$ avec $\Delta V$ le bruit en tension intégré de 0 à la limite inférieure de la bande passante. Cela permet notamment de diminuer l'impact des fluctuations de la polarisation sur le bruit de l'amplificateur.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre un amplificateur à jonction Josephson selon l'état de l'art antérieur.
- La figure 2 montre un circuit d'adaptation selon un premier mode de réalisation d'un premier aspect de l'invention.
- La figure 3 montre un graphique présentant la partie réelle de l'impédance en fonction de la fréquence d'un circuit d'adaptation selon un premier mode de réalisation d'un premier aspect de l'invention.
- La figure 4 montre un graphique présentant la partie réelle de l'impédance en fonction de la fréquence d'un circuit d'adaptation selon une première variante d'un premier mode de réalisation d'un premier aspect de l'invention.
- La figure 5 montre un graphique présentant la partie réelle de l'impédance en fonction de la fréquence d'un circuit d'adaptation selon une deuxième variante d'un premier mode de réalisation d'un premier aspect de l'invention.
- La figure 6 montre un circuit d'adaptation selon un deuxième mode de réalisation d'un premier aspect de l'invention.
- La figure 7 montre un graphique présentant la partie réelle de l'impédance en fonction de la fréquence d'un circuit d'adaptation selon un deuxième mode de réalisation d'un premier aspect de l'invention.
- La figure 8 montre un circuit d'adaptation selon un troisième mode de réalisation d'un premier aspect de l'invention.
- La figure 9 montre un graphique présentant la partie réelle de l'impédance en fonction de la fréquence d'un circuit d'adaptation selon un troisième mode de réalisation d'un premier aspect de l'invention.
- La figure 10 montre un amplificateur à jonction Josephson selon un mode de réalisation d'un deuxième aspect de l'invention.

## DESCRIPTION DETAILLEE D'AU MOINS UN MODE DE REALISATION DE L'INVENTION

Sauf précision contraire, un même élément apparaissant sur des figures différentes présente une référence unique. Tous les modes de réalisation suivants ont été conçus dans le cas où le terminal d'entrée/sortie ES est destiné à être connecté ou est connecté à une ligne d'impédance $Z_0$ égale à 50 Ω.

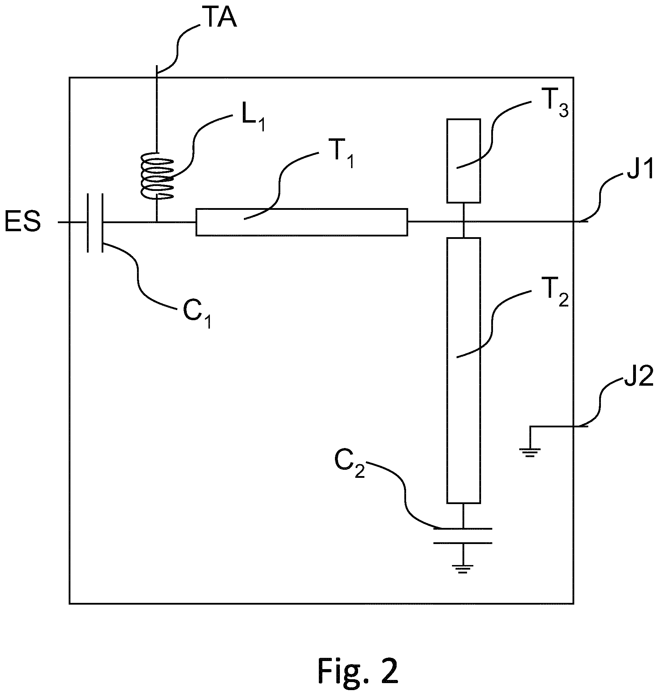

Un circuit d'adaptation destiné à être connecté à une impédance non-linéaire L comprenant un supraconducteur selon un premier mode de réalisation d'un premier aspect de l'invention est illustré à la figure 2. Le circuit d'adaptation comprend un premier terminal dit premier port de connexion J1 destiné à être connecté à une première borne B1 de l'impédance non-linéaire L, un deuxième terminal dit deuxième port de connexion J2 destiné à être connecté à une deuxième borne B2 de l'impédance non-linéaire L, un troisième terminal dit terminal d'entrée/sortie ES destiné à recevoir le signal à amplifier, l'amplification se faisant avec un gain en puissance G et sur une bande passante BW, et un quatrième terminal dit terminal d'alimentation TA destiné à être connecté à une source de polarisation ST et configuré pour qu'une tension V soit appliquée entre le premier port de connexion J1 et le deuxième port de connexion J2.

Le circuit d'adaptation comporte également une pluralité de composants électriques passifs ($T_1$, $T_2$, $T_3$, $C_1$, $C_2$, $L_1$) configurés de sorte que l'impédance Z(f) entre le premier port de connexion J1 et le deuxième port de connexion J2 pour un signal de fréquence f a une partie réelle Re(Z(f)) telle que :

- $Re(Z(f_s)) > 0$ avec $f_s$ une première fréquence dite fréquence signal ;
- $Re(Z(f_i)) > 0$ avec $f_i$ une deuxième fréquence dite fréquence idler ;

- $Re(Z(0)) < \dfrac{h}{4e^2} \dfrac{f_p}{G.BW}$ avec $f_p$ une troisième fréquence dite fréquence pompe ;

-

$$Re(Z(f_p + f_s)) < \frac{f_p + f_s}{f_i} Re(Z(f_i)).$$

En outre, la fréquence pompe est choisie de sorte que $nf_p = f_s + f_i$ avec n un entier appartenant à [1, +∞] et la fréquence idler est choisie de sorte que $f_i > \dfrac{k_B T}{h}$ avec T la température du circuit, $k_B$ la constante de Boltzmann et h la constante de Planck. Comme cela a été précisé auparavant, les fréquences signal $f_p + f_s$ et $f_p - f_s$ sont ici traitées différemment. Cette différence s'explique par le fait que les inventeurs utilise une interprétation quantique qui donne un sens très différent aux bandes $f_p + f_s$ et $f_p - f_s$ :

- la bande $f_p - f_s$ est due à un processus où chaque paire de Cooper qui tunnel à travers la jonction donne un photon à la fréquence $f_s$ et un photon à la fréquence $f_p - f_s$ ce qui amplifie le signal à la fréquence $f_s$ (effet d'émission stimulée) et donne lieu à un bruit ajouté d'un demi-photon $hf_s$ (effet d'émission spontanée) ;
- la bande $f_p + f_s$ est due à un processus où chaque paire de Cooper est décalée en fréquence de la fréquence $f_s$ à la fréquence $f_p + f_s$ en absorbant l'énergie d'une paire de Cooper qui tunnel ce qui conduit à l'absorption du signal à la fréquence $f_s$ sans ajouter de bruit.

Si les deux processus ont la même intensité, le processus associé à la fréquence $f_p + f_s$ fait perdre la moitié du signal incident et seulement l'autre moitié peut être amplifiée ce qui équivaut à réduire le gain en puissance d'un facteur deux. De plus, le bruit se trouve augmenté d'un facteur deux pour passer d'un demi-photon $h\dfrac{f}{2}$ à un photon hf. Donc, si la bande $f_p + f_s$ peut être fortement réduite en minimisant l'impédance à la fréquence $f_p + f_s$ comme le propose l'invention, il est possible de tendre vers le bruit optimal.

Dans le mode de réalisation illustré à la figure 2, une partie des éléments électriques passifs est réalisé à l'aide de segments de guide d'onde (ou CPW pour CoPlanar Waveguide en anglais). Ces derniers peuvent être réalisés dans un matériau supraconducteur afin de minimiser les pertes par effet joule et donc le bruit thermique au niveau du circuit. Pour rappel, un CPW d'impédance $Z_0$ et de longueur l se terminant par une impédance $Z_L$ a une impédance $Z_{in}$ mesurée

à l'entrée du CPW donnée par $Z_{in} = \dfrac{Z_L + j\, Z_0 \tan(\beta l)}{Z_0 + j Z_L \tan(\beta l)} Z_0$ où $\beta$ est la constante de propagation. L'impédance des segments de guide d'onde est donc facile à contrôler par l'intermédiaire de leurs dimensions ce qui rend leur utilisation très avantageuse. Cependant, il est également possible d'utiliser des éléments électriques passifs tels que des capacités ou des inductances, par exemple lorsque les exigences de dimensions ne sont pas compatibles avec l'utilisation de segments de guide d'onde.

Plus particulièrement, le circuit d'adaptation illustré à la figure 2 comporte un premier segment de guide d'onde $T_1$ dont une première extrémité est connectée au terminal d'alimentation TA par l'intermédiaire d'une inductance $L_1$ et au terminal d'entrée/sortie ES par l'intermédiaire d'une première capacité $C_1$ et une deuxième extrémité est connectée au premier port de connexion J1. Comme nous le verrons dans la suite, ce premier segment de guide d'onde $T_1$ permet de transformer l'impédance de sorte à favoriser une large bande de fréquence ou un bruit optimal en fonction des applications envisagées.

Le circuit comporte également un deuxième segment de guide d'onde $T_2$ dont une première extrémité est connectée à la masse par l'intermédiaire d'une deuxième capacitance $C_2$ et une deuxième extrémité est connectée au premier port de connexion J1. La deuxième capacité est choisie de sorte à se comporter en court-circuit aux fréquences $f_i$, $f_s$ et $f_p$.

De plus, le circuit comporte un troisième segment de guide d'onde $T_3$ dont une première extrémité est connectée à une impédance infinie (c'est-à-dire un circuit ouvert) et dont une deuxième extrémité est connectée au premier port de connexion J1. Enfin, le deuxième port de connexion J2 est connecté à la masse.

Dans un premier exemple de réalisation, on choisit $f_p = 12\,\text{GHz}$ et $f_s = f_i = 6\,\text{GHz}$. Le premier segment de guide d'onde $T_1$ a une longueur $l = \dfrac{\lambda_s}{4}$, avec $\lambda_s$ la longueur d'onde associée à la fréquence $f_s$ et une impédance $Z_1$ égale à $50\,\Omega$. Le deuxième segment de guide d'onde $T_2$ a une longueur $l = \dfrac{\lambda_p}{2}$, avec $\lambda_p$ la longueur d'onde associée à la fréquence $f_p$ et une impédance $Z_2$ égale à $150\,\Omega$. Ce CPW permet donc de produire des antirésonances de l'impédance entre la premier port de connexion J1 et le deuxième port de connexion J2 aux fréquences $k \times f_p$ avec $k \in [1, +\infty]$ et a une fréquence proche de la fréquence nulle, mais permet d'appliquer une tension DC au niveau du port de connexion J1. Autrement dit, la partie réelle de l'impédance $Re(Z(f))$ est nulle auxdites fréquences. Le troisième segment de guide d'onde $T_3$ a une longueur $l = \dfrac{\lambda_{p+s}}{4}$, avec $\lambda_{p+s}$ la longueur d'onde associée à la fréquence $f_p + f_s$, et une impédance $Z_3$ égale à $150\,\Omega$. Ce CPW permet donc de produire des antirésonances aux fréquences $k' \times (f_p + f_s)$ avec $k'$ un nombre impair et $k' \in [1, +\infty]$. En effet, lorsque la fréquence est égale à $k' \times (f_p + f_s)$ avec $k'$ un nombre impair et $k' \in [1, +\infty]$, l'impédance mesurée au niveau du premier port de connexion J1 est égale à $\dfrac{Z_3^2}{Z_L}$, $Z_L$ étant l'impédance de terminaison du segment de guide d'onde. Or, dans le cas du troisième segment de guide d'onde $T_3$, $Z_L = +\infty$ et donc l'impédance mesurée au niveau du premier port de connexion J1 est nulle.

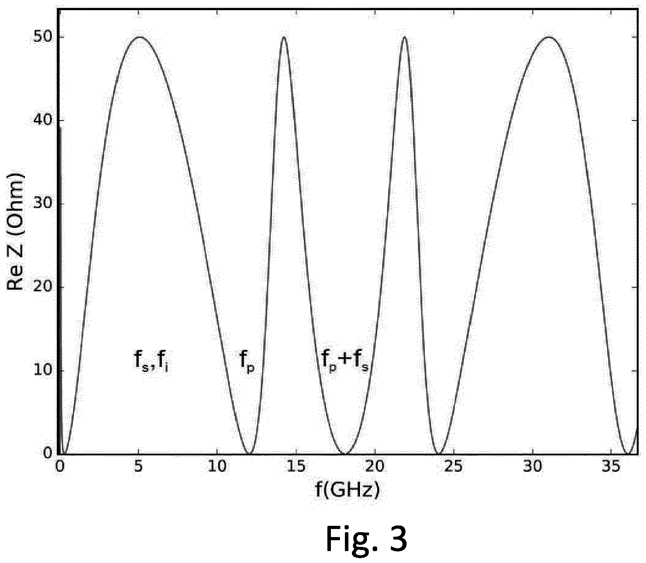

La partie réelle de l'impédance en fonction de la fréquence de ce mode particulier de réalisation est illustrée à la figure 3. L'impédance est nulle pour les fréquences pompe $f_p$, signal plus pompe $f_s + f_p$, idler plus pompe $f_p + f_i$ ainsi que la première harmonique de la fréquence pompe $2f_p$. En outre, l'impédance présente bien une impédance élevée (donc non nulle) aux fréquences $f_s$ et $f_i$. Plus particulièrement, l'impédance mesuré présente un maximum local aux fréquences $f_s$ et $f_i$. La structure de la figure 2 remplit donc toutes les conditions évoquées précédemment.

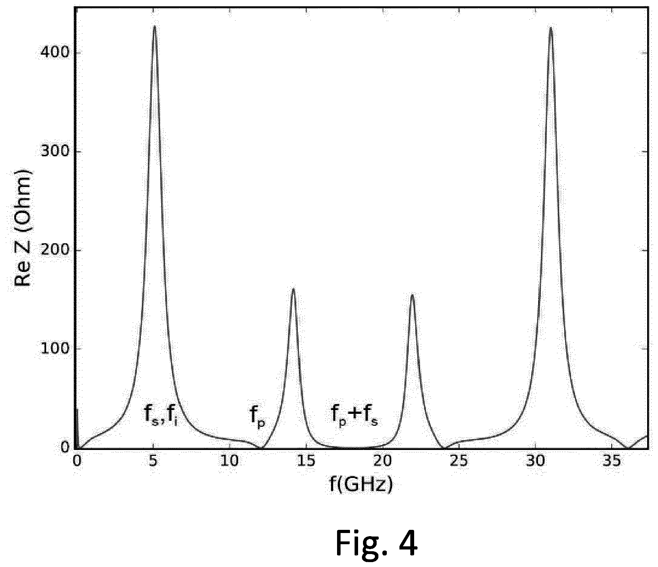

Dans une variante de ce premier exemple de réalisation, l'impédance $Z_1$ du premier guide d'onde $T_1$ est choisie égale à $150\,\Omega$. La partie réelle de l'impédance en fonction de la fréquence de cet exemple de réalisation est illustrée à la figure 4. On peut noter que si les résonances apparaissent aux mêmes fréquences que précédemment, les pics associés à ces résonances sont plus élevés et plus étroits. Autrement dit, il est possible de modifier le gain et la bande passante d'un amplificateur comprenant un tel circuit en modifiant la valeur de l'impédance $Z_1$ du premier guide d'onde $T_1$. Dans le premier exemple de réalisation, la valeur de cette impédance permet d'obtenir une large bande passante autour de la fréquence signal $f_s$ avec toutefois un minimum à la fréquence $f_p + f_s$ étroit et donc une plage de fréquences où le bruit est optimal plus étroite. Dans la variante de ce premier exemple de réalisation, la bande passante autour de la fréquence signal $f_s$ est réduite mais permet d'obtenir un minimum à la fréquence $f_p + f_s$ plus large et donc une plage de fréquences où le bruit est optimal plus large.

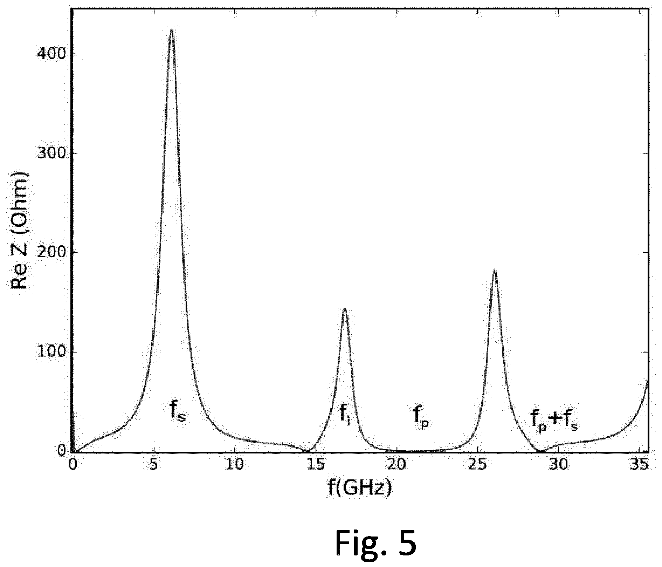

Dans un troisième exemple de réalisation, on choisit $f_s = 6\,\text{GHz}$, $f_i = 16.8\,\text{GHz}$ et $f_p = 22.8\,\text{GHz}$. Dans ce troisième exemple de réalisation, le premier segment de guide d'onde $T_1$ a une longueur $l = \dfrac{\lambda_1}{4}$, avec $\lambda_1$ la longueur d'onde associée à la fréquence $f_1$ = 7.25GHz et une impédance $Z_1$ égale à 150 Ω. Le deuxième segment de guide d'onde $T_2$ a une longueur $1 = \frac{\lambda_2}{2}$, avec $\lambda_2$ la longueur d'onde associée à la fréquence $f_2$ = 14.5GHz et une impédance $Z_2$ égale à 150 Ω. Le troisième segment de guide d'onde $T_3$ a une longueur $1 = \frac{\lambda_3}{4}$, avec $\lambda_3$ la longueur d'onde associée à la fréquence $f_3$ = 21.5GHz et une impédance $Z_2$ égale à 150 Ω. La partie réelle de l'impédance en fonction de la fréquence de ce mode particulier de réalisation est illustrée à la figure 5. Dans cet exemple de réalisation, il apparaît clairement que la fréquence du signal à amplifier $f_s$ peut être différente de la fréquence idler $f_i$ et avantageusement plus basse que cette dernière.

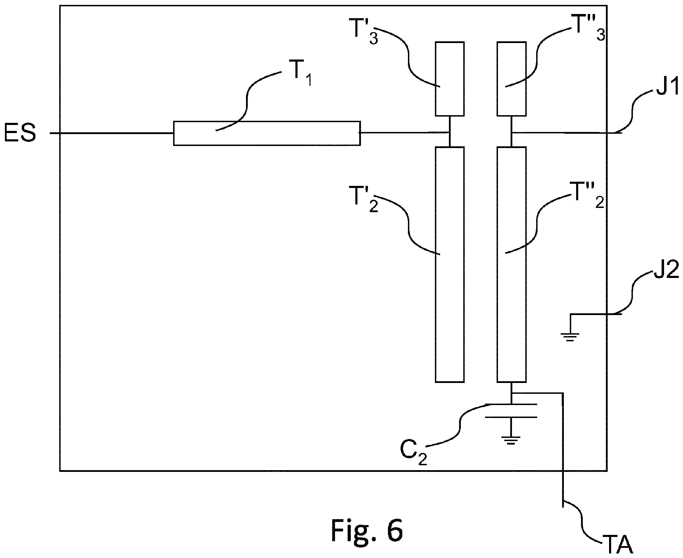

Pour optimiser à la fois la bande passante BW à la fréquence signal $f_s$ et la largeur de la plage de fréquences où le bruit est optimal, un deuxième mode de réalisation d'un premier aspect de l'invention est illustré à la figure 6.

Dans ce mode de réalisation, le circuit d'adaptation comporte un premier segment de guide d'onde $T_1$ dont une première extrémité est connectée au terminal au terminal d'entrée/sortie ES et une deuxième extrémité est connectée à une première extrémité d'un deuxième guide d'onde $T'_2$ et à une première extrémité d'un troisième guide d'onde $T'_3$. Les deuxièmes extrémités du deuxième guide d'onde $T'_2$ et troisième guide d'onde $T'_3$ sont quant à elles chacune connectée à une impédance infinie (c'est-à-dire un circuit ouvert). Le deuxième segment de guide d'onde $T'_2$ est en outre couplé de manière capacitive à un quatrième guide d'onde $T''_2$ et le troisième segment de guide d'onde $T'_3$ est en outre couplé de manière capacitive à un cinquième guide d'onde $T''_3$ de sorte à former un coupleur. Une première extrémité du quatrième guide d'onde $T''_2$ est connectée à la masse par l'intermédiaire d'une capacité $C_2$ et au terminal d'alimentation TA. Une deuxième extrémité du quatrième guide d'onde $T''_2$ est connectée au premier port de connexion J1. Une première extrémité du cinquième guide d'onde $T''_3$ est connectée à une impédance infinie (c'est-à-dire un circuit ouvert). Une deuxième extrémité du cinquième guide d'onde $T''_3$ est connectée au premier port de connexion J1. Le deuxième port de connexion J2 est quant à lui connecté à la masse.

Contrairement au premier mode de réalisation évoqué précédemment, le premier segment de guide d'onde $T_1$ permet de transformer l'impédance de sorte à favoriser une large bande de fréquence sans compromis sur le bruit optimal.

Dans un exemple de réalisation, on choisit $f_p$ = 12GHz et $f_s$ = $f_i$ = 6 GHz. Dans cet exemple de réalisation, le premier segment de guide d'onde T1 a une longueur $1 = \frac{\lambda_s}{3.28}$ avec $\lambda_s$ la longueur d'onde associée à la fréquence signal $f_s$ et une impédance $Z_1$ égale à 42.5 Ω. Le deuxième segment de guide d'onde $T'_2$ et le quatrième segment de guide d'onde $T''_2$ ont une longueur $1 = \frac{\lambda_p}{3}$ avec $\lambda_p$ la longueur d'onde associée à la fréquence $f_p$ et des impédances paire $Z_{2P}$ égale à 90 Ω et impaire $Z_{2I}$ égale à 9Ω (ces deux impédances sont dues au couplage entre le deuxième segment de guide d'onde $T'_2$ et le quatrième segment de guide d'onde $T''_2$). En outre, le troisième segment de guide d'onde $T'_3$ et le cinquième segment de guide d'onde $T''_3$ ont une longueur $1 = \frac{\lambda_p}{6}$ avec $\lambda_p$ la longueur d'onde associée à la fréquence $f_p$ et des impédances paire $Z_{3P}$ égale à 90 Ω et impaire $Z_{3I}$ égale à 9 Ω (ces deux impédances sont dues au couplage entre le troisième segment de guide d'onde et le cinquième segment de guide d'onde).

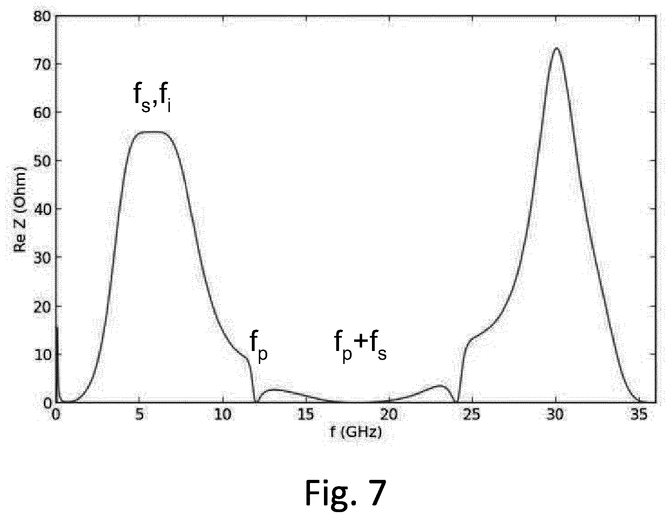

L'amplitude de la partie réelle de l'impédance en fonction de la fréquence obtenue avec cet exemple de réalisation est illustrée à la figure 7. Comme précédemment, l'impédance présente bien une impédance élevée (donc non nulle) aux fréquences $f_s$ et $f_i$. Plus particulièrement, l'impédance présente un plateau d'impédance élevé large de plusieurs GHz autour des fréquences signal $f_s$ et idler $f_i$. Autrement dit, un amplificateur comprenant un tel circuit présentera une large bande de fréquence autour de la fréquence signal $f_s$ dans laquelle le signal sera amplifié. De la même manière, l'impédance est sensiblement égale à zéro pour les fréquences $f_p$ et $f_p$ + $f_s$ ainsi qu'à des fréquences faibles. L'impédance obtenue avec cette structure remplit donc les critères établis précédemment à savoir un bruit inférieur à 1 photon et permet en outre de séparer la partie DC du circuit de la partie AC.

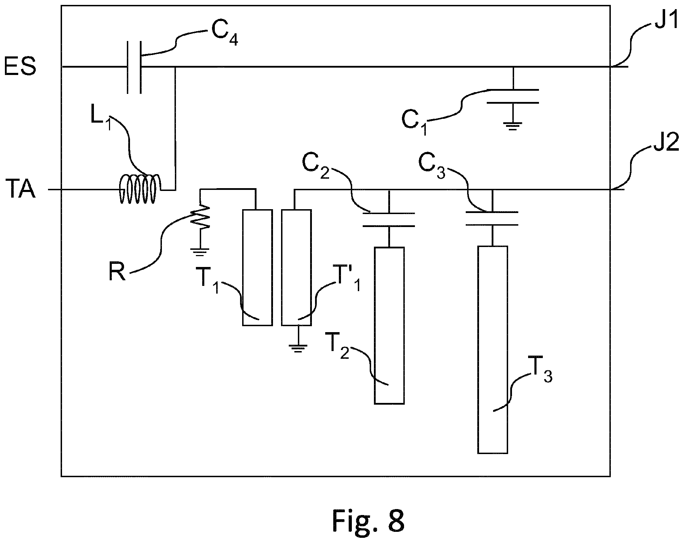

Un troisième mode de réalisation d'un circuit d'adaptation selon un premier aspect de l'invention est illustré à la figure 8. Dans ce mode de réalisation, le premier port de connexion J1 est connecté au terminal d'entrée/sortie ES par l'intermédiaire d'une quatrième capacité $C_4$. Le premier port de connexion J1 est également connecté à la masse par l'intermédiaire d'une première capacité $C_1$ et au terminal d'alimentation TA par l'intermédiaire d'une inductance $L_1$. Le circuit comporte également un premier segment de guide d'onde $T_1$ dont une première extrémité est connectée à une impédance infinie (c'est-à-dire un circuit ouvert) et dont une deuxième extrémité est connectée à la masse par l'intermédiaire d'une résistance R. Le circuit comporte également un deuxième segment de guide d'onde $T_2$ dont une première extrémité est à une impédance infinie (c'est-à-dire un circuit ouvert) et dont une deuxième extrémité est connectée au deuxième port de connexion J2 par l'intermédiaire d'une deuxième capacité $C_2$. Le circuit comporte en outre un troisième segment de guide d'onde $T_3$ dont une extrémité est connectée à une impédance infinie (c'est-à-dire à un circuit ouvert) et dont une deuxième extrémité est connectée au deuxième port de connexion J2 par l'intermédiaire d'une troisième capacité $C_3$. Le circuit comporte également un quatrième segment de guide d'onde $T_1'$ dont une première extrémité est connectée à la masse et dont une deuxième extrémité est connectée au deuxième port de connexion J2. De plus, le premier segment de guide d'onde $T_1$ est couplé de manière capacitive au quatrième guide d'onde $T_1'$.

Dans un exemple de réalisation, on choisit $f_p$ = 300GHz, $f_i$ = 290GHz et $f_s$ = 10GHz. Dans cet exemple de réalisation, le premier segment de guide d'onde $T_1$ et le quatrième segment de guide d'onde $T_1'$ ont une longueur $l = \frac{\lambda_1}{4}$ avec $\lambda_1$ la longueur d'onde associée à la fréquence $f_1$ = 310 GHz, une impédance paire $Z_{1P}$ égale à 25 $\Omega$ et une impédance impaire $Z_{1I}$ égale à 20 $\Omega$ (ces deux impédances sont dues au couplage entre le premier segment de guide d'onde et le quatrième segment de guide d'onde).

Le deuxième segment de guide d'onde $T_2$ a une longueur $l = \frac{\lambda_2}{2}$ avec $\lambda_2$ la longueur d'onde associé à la fréquence $f_2$ = 320 GHz et une impédance $Z_2$ égale à 50 $\Omega$. De plus, la deuxième capacité $C_2$ a une impédance de 1 fF. Ainsi l'association du deuxième segment de guide d'onde $T_2$ et de la deuxième capacité $C_2$ permet d'obtenir une antirésonance à $f_p$ + $f_s$ (c'est-à-dire 310GHz).

Le troisième segment de guide d'onde $T_3$ a une longueur $l = \frac{\lambda_3}{2}$ avec $\lambda_3$ la longueur d'onde associée à la fréquence $f_3$ = 304,6GHz et une impédance $Z_3$ égale à 50 $\Omega$. De plus, la troisième capacité $C_3$ a une impédance de 0.5 fF. Ainsi l'association du troisième segment de guide d'onde $T_3$ et de la troisième capacité $C_3$ permet d'obtenir une antirésonance à $f_p$ (c'est-à-dire 300GHz).

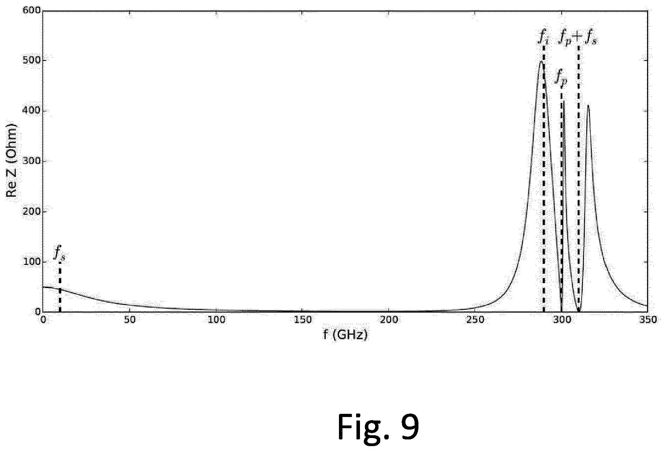

En outre, la première capacité $C_1$ a une impédance de 100 fF, la quatrième capacité $C_4$ a une impédance de 100 pF, l'inductance $L_1$ a une impédance de 100nH et la résistance R a une impédance de 5 $\Omega$. Dans cet exemple de réalisation, la quatrième capacité $C_4$ et l'inductance $L_1$ permettent de contrôler la fréquence de coupure basse (environ 80MHz). Il est également possible de choisie des valeurs d'impédance pour ces éléments cent fois plus petites pour centrer la bande passante autour de 10 GHz. L'amplitude de la partie réelle de l'impédance en fonction de la fréquence obtenue avec cet exemple de réalisation est illustrée à la figure 9.

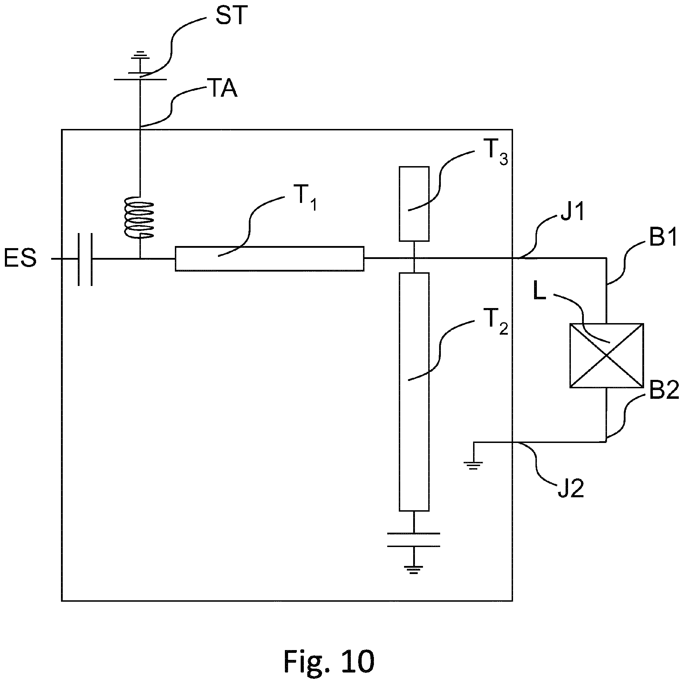

Les trois modes de réalisation précédents démontrent à travers quatre exemples comment obtenir un circuit d'adaptation présentant les caractéristiques nécessaires à l'obtention d'un amplificateur à bas bruit. Il est donc possible, à partir d'un circuit d'adaptation selon un premier aspect de l'invention, de réaliser un amplificateur bas bruit. Un tel amplificateur est illustré à la figure 10.

Cet amplificateur comporte une impédance non-linéaire sous la forme d'une jonction Josephson L. Le matériau supraconducteur de la jonction est choisi de sorte que $f_s < \frac{2\Delta}{h}$ avec $\Delta$ le gap supraconducteur du matériau supraconducteur. Afin de polariser l'impédance de la jonction en tension, l'amplificateur comporte également une source de polarisation, ici sous la forme d'une source de tension ST. Cette dernière est connectée par le biais de la connexion en T de sorte à appliquer une tension V aux bornes de la jonction Josephson L. La présence de cette connexion en T permet de s'assurer que les signaux haute fréquence proviennent ou sont envoyés sur le port d'entrée/sortie ES tandis que les signaux basses fréquences proviennent ou sont envoyés sur le terminal d'alimentation TA.

Dans un exemple de réalisation, on choisit un circuit d'adaptation selon le premier exemple de réalisation, autrement dit, on choisit $f_p$ = 12GHz et $f_s$ = $f_i$ = 6GHz. La source de polarisation est configurée pour appliquer une tension $V = 12\text{GHz} \times \frac{h}{2e}$ afin de fournir l'énergie nécessaire aux paires de Cooper de la jonction pour générer les photons à la fréquence signal $f_s$ et à la fréquence idler $f_i$. Pour ces fréquences, le matériau peut être choisi parmi tous les supraconducteurs comme par exemple l'aluminium. Pour des fréquences plus élevées (quelques centaines de GHz), il sera avantageux de choisir par exemple le nitrure de niobium qui a un gap supraconducteur mieux adapté à ces hautes fréquences.

Dans cet exemple de réalisation, l'impédance non-linéaire est constituée par une jonction Josephson. L'utilisation d'une jonction Josephson apporte un avantage en termes de fabrication, une telle jonction étant facile à obtenir. En revanche, lorsque l'on fabrique un grand nombre de dispositifs, il peut être difficile d'avoir une bonne homogénéité dans les propriétés des différentes jonctions Josephson notamment en termes de courant critique. Or, dans l'amplificateur selon l'invention, le gain est directement dépendant du courant critique. Autrement dit, lorsque l'on utilise une jonction Josephson comme impédance non-linéaire, le gain d'amplification peut varier d'un amplificateur à un autre.

Afin de palier à cet inconvénient, dans un deuxième mode de réalisation d'un deuxième aspect de l'invention, il est donc fait avantageusement usage d'un SQUID (de l'anglais Superconducting Quantum Interference Device). Pour mémoire, un SQUID se présente sous la forme d'une boucle supraconductrice comprenant deux jonctions Josephson. Le courant critique d'une telle structure peut être modulé en faisant varier le flux magnétique traversant la boucle au moyen d'un champ magnétique. Il est donc possible d'ajuster in-situ le courant critique du SQUID et donc le gain de l'amplificateur utilisant un tel SQUID. Un champ magnétique peut par exemple être appliqué au moyen d'une ligne électrique proche du SQUID et dans laquelle circule un courant.

## Revendications

1.  Circuit d'adaptation d'impédance destiné à être connecté à une impédance non-linéaire (L) comprenant un supraconducteur (JJ), ledit circuit comportant un premier terminal dit premier port de connexion (J1) destiné à être connecté à une première borne (B1) de l'impédance non-linéaire (L), un deuxième terminal dit deuxième port de connexion (J2) destiné à être connecté à une deuxième borne (B2) de l'impédance non-linéaire (L), un troisième terminal dit terminal d'entrée/sortie (ES) destiné à recevoir le signal à amplifier avec un gain en puissance G et une bande passante BW et un quatrième terminal dit terminal d'alimentation (TA) destiné à être connecté à une source de polarisation (ST) et configuré pour qu'une tension V soit appliquée entre le premier port de connexion (J1) et le deuxième port de connexion (J2), ledit circuit comportant en outre une pluralité de composants électriques passifs configurés de sorte que l'impédance $Z(f)$ entre le premier port de connexion (J1) et le deuxième port de connexion (J2) pour un signal de fréquence f a une partie réelle $Re(Z(f))$ telle que :

    - $Re(Z(f_s)) > 0$ avec $f_s$ une première fréquence dite fréquence du signal à amplifier ;
    - $Re(Z(f_i)) > 0$ avec $f_i$ une deuxième fréquence dite fréquence idler ;

    - $Re(Z(0)) < \dfrac{h}{4e^2} \dfrac{f_p}{G.BW}$ avec $f_p$ une troisième fréquence dite fréquence pompe ;

    -

    $$Re(Z(f_p + f_s)) < \frac{f_p + f_s}{f_i} Re(Z(f_i)) \; ;$$

    la fréquence de pompe étant choisie de sorte que $nf_p = f_s + f_i$ avec n un entier appartenant à [1, +∞] et la fréquence idler étant choisies de sorte que $f_i > \dfrac{k_B T}{h}$ avec T la température du circuit, $k_B$ la constante de Boltzmann et h la constante de Planck.

2.  Circuit selon la revendication précédente dans lequel $Re(Z(f_p + f_s)) < \dfrac{Re(Z(f_i))}{10}$.

3.  Circuit selon l'une des revendications précédentes dans lequel $Re(Z(0)) < \dfrac{h}{4e^2} \dfrac{1}{10G}$.

4.  Circuit selon l'une des revendications précédentes dans lequel $Re(Z(f_p)) < \dfrac{4e^2}{h} BW \dfrac{f_p}{f_s.f_i} Re(Z(f_s)) Re(Z(f_i))$.

5.  Circuit selon l'une des revendications précédentes dans lequel le terminal d'entrée/sortie (ES) est destiné à être connecté à une impédance de valeur $Z_0$ et $Re(Z(f_s)) < 2 \dfrac{|Z_{trans}(f_s)|^2}{Z_0} Re(Z(f_s))$ avec $Z_{trans}(f_s)$ la tension au niveau du terminal d'entrée/sortie (ES) lorsqu'un courant unitaire de fréquence $f_s$ est appliqué entre le premier port de connexion (J1) et le deuxième port de connexion (J2).

6.  Circuit selon l'une des revendications précédentes dans lequel $Re(Z(f_p + f_i)) < \dfrac{f_p + f_i}{f_s} Re(Z(f_s))$.

7.

Circuit selon l'une des revendications précédentes dans lequel $f_i > 4\dfrac{k_B T}{h}$.

**8.** Circuit selon l'une des revendications précédentes dans lequel n = 1.

**9.** Circuit selon l'une des revendications précédentes dans lequel $\max\{\operatorname{Re}(Z(f_s)), \operatorname{Re}(Z(f_i))\} < \dfrac{h}{4e^2}$.
$\max\{\operatorname{Re}(Z(f_s)),$

**10.** Circuit selon l'une des revendications précédentes dans lequel la pluralité de composants électriques passifs comporte :

- un premier segment de guide d'onde ($T_1$) dont une première extrémité est connectée au terminal d'alimentation (TA) par l'intermédiaire d'une inductance ($L_1$) et au terminal d'entrée/sortie (ES) par l'intermédiaire d'une première capacité ($C_1$) et une deuxième extrémité est connectée au premier port de connexion (J1) ;
- un deuxième segment de guide d'onde ($T_2$) dont une première extrémité est connectée à la masse par l'intermédiaire d'une deuxième capacité ($C_2$) et une deuxième extrémité est connectée au premier port de connexion (J1) ;
- un troisième segment de guide d'onde ($T_3$) dont une première extrémité est connectée à une impédance infinie et une deuxième extrémité est connectée au premier port de connexion (J1) ;

et en ce que le deuxième port de connexion (J2) est connecté à la masse

**11.** Amplificateur à réflexion comportant un circuit d'adaptation d'impédance selon l'une des revendications précédentes, une source de polarisation (ST) connectée au terminal d'alimentation (TA), une impédance non linéaire (L) comprenant un supraconducteur ladite impédance non-linéaire (L) comportant une premier borne (B1) et une deuxième borne (B2), la première borne (B1) de l'impédance (L) étant connectée au premier port (J1) de connexion du circuit d'adaptation, la deuxième borne (B2) de l'impédance (L) étant connectée au deuxième port (J2) de connexion du circuit d'adaptation, amplificateur dans lequel la tension appliquée entre le premier terminal de connexion (J1) et le deuxième terminal de connexion (J2) au moyen de la source de tension (ST) est choisie de sorte que $f_p = \dfrac{2eV}{h}$ avec 2e la charge électrique d'une paire de Cooper et h la constante de Planck.

**12.** Amplificateur selon la revendication précédente dans lequel le matériau supraconducteur de l'impédance non-linéaire (L) est choisi de sorte que $f_s < \dfrac{2\Delta}{h}$ avec $\Delta$ le gap supraconducteur du supraconducteur.

**13.** Amplificateur selon l'une des deux revendications précédentes dans lequel l'impédance non-linéaire (L) comprend une jonction Josephson (JJ).

**14.** Amplificateur selon la revendication précédente dans lequel la jonction Josephson est de type Supraconducteur/Isolant/Supraconducteur.

**15.** Amplificateur selon l'une des quatre revendications précédentes dans lequel l'impédance non-linéaire (L) supraconductrice comprend un SQUID.

**Patentansprüche**

**1.** Impedanz-Anpassungsschaltung, die dazu bestimmt ist, an eine nicht lineare Impedanz (L) angepasst zu sein, umfassend einen Supraleiter (JJ), wobei die genannte Schaltung ein erstes Terminal, bezeichnet als erster Anschlussport (J1), der dazu bestimmt ist, an eine erste Buchse (B1) der nicht linearen Impedanz (L) angeschlossen zu sein, ein zweites Terminal, bezeichnet als zweiter Anschlussport (J2), der dazu bestimmt ist, an einen zweiten Anschluss (B2) der nicht linearen Impedanz (L) angeschlossen zu sein, ein drittes Terminal, bezeichnet als Eingangs-/Ausgangs-Terminal (ES), das dazu bestimmt ist, das zu verstärkende Signal mit einer Leistungszunahme G und einer Bandbreite BW zu empfangen, und ein viertes Terminal, bezeichnet als Versorgungsterminal (TA), das dazu bestimmt ist, an eine Polarisationsquelle (ST) angeschlossen zu sein und ausgestaltet ist, damit eine Spannung V zwischen dem ersten Anschlussport (J1) und dem zweiten Anschlussport (J2) angewendet ist, umfasst, wobei die genannte Schaltung darüber hinaus eine Vielzahl von passiven elektrischen Bauteilen umfasst; die derart ausgestaltet sind, dass die Impedanz Z(f)) zwischen dem ersten Anschlussport (J1) und dem zweiten Anschlussport (J2) für ein Frequenzsignal f einen realen Teil Re(Z(f)) derart aufweist, dass:

- Re($Z(f_s)$) > 0, wobei $f_s$ eine erste Frequenz, bezeichnet als Frequenz des zu verstärkenden Signals, ist;
- - Re($Z(f_i)$) > 0, wobei $f_i$ eine zweite Frequenz, bezeichnet als "Idler-Frequenz", ist;

- - $Re(Z(0)) < \dfrac{h}{4e^2}\dfrac{f_p}{G.BW}$, wobei $f_p$ eine dritte Frequenz, bezeichnet als Pumpfrequenz, ist;

- - $Re\big(Z(f_p + f_s)\big) < \dfrac{f_p+f_s}{f_i}Re(Z(f_i))$;

wobei die Pumpfrequenz derart ausgewählt ist, dass $nf_p = f_s + f_i$, wobei n eine ganze Zahl ist, die zu [1, +∞] gehört und die Idler-Frequenz derart ausgewählt ist, dass $f_i > \dfrac{k_B T}{h}$ ist, wobei T die Temperatur der Schaltung ist, $k_B$ die Boltzmann-Konstante und h die Planck-Konstante ist.

2. Schaltung gemäß dem voranstehenden Anspruch, bei der Re($Z(f_p + f_s)$) < $\dfrac{Re(Z(f_i))}{10}$ ist.

3. Schaltung gemäß irgendeinem der voranstehenden Ansprüche, bei der $Re(Z(0)) < \dfrac{h}{4e^2}\dfrac{1}{10G}$ ist.

4. Schaltung gemäß einem der voranstehenden Ansprüche, bei der

$Re\big(Z(f_p)\big) < \dfrac{4e^2}{h}BW\dfrac{f_p}{f_s.f_i}Re\big(Z(f_s)\big)Re(Z(f_i))$.

5. Schaltung gemäß einem der voranstehenden Ansprüche, bei der das Eingangs- / Ausgangsterminal (ES) dazu bestimmt ist, an einen Impedanzwert $Z_0$ und $Re\big(Z(f_s)\big) < 2\dfrac{|Z_{trans}(f_s)|^2}{Z_0}$ Re($Z(f_s)$) angeschlossen zu sein, wobei $Z_{trans}(f_s)$ die Spannung am Eingangs-/ Ausgangsterminal (ES) ist, wenn ein einheitlicher Strom der Frequenz $f_s$ zwischen dem ersten Anschlussport (J1) und dem zweiten Anschlussport (J2) angewendet ist.

6. Schaltung gemäß einem der voranstehenden Anschlüsse, bei der $Re(Z(f_p + f_i)\big) < \dfrac{f_p+f_i}{f_s}Re(Z(f_s))$ ist.

7. Schaltung gemäß einem der voranstehenden Ansprüche, bei der $f_i > 4\dfrac{k_B T}{h}$ ist.

8. Schaltung gemäß einem der voranstehenden Ansprüche, bei der n = 1 ist.

9. Schaltung gemäß einem der voranstehenden Ansprüche, bei der $\max\big\{Re\big(Z(f_s)\big), Re\big(Z(f_i)\big)\big\} < \dfrac{h}{4e^2}$ ist.

10. Schaltung gemäß einem der voranstehenden Ansprüche, bei der die Vielzahl von passiven elektrischen Bauteilen umfasst:

- ein erstes Wellen-Führungssegment ($T_1$), von dem ein erstes Ende an das Versorgungsterminal (TA) mittels einer Induktanz ($L_1$) und an das Eingangs- / Ausgangs-Terminal (ES) mittels einer ersten Kapazität ($C_1$) angeschlossen ist und ein zweites Ende an den ersten Anschlussport (J1) angeschlossen ist;
- ein zweites Wellen-Führungssegment ($T_2$), von dem ein erstes Ende an die Masse mittels einer zweiten Kapazität ($C_2$) angeschlossen ist und ein zweites Ende an den ersten Anschlussport (J1) angeschlossen ist;
- ein drittes Wellen-Führungssegment ($T_3$), von dem ein erstes Ende an eine unendliche Impedanz angeschlossen ist, und ein zweites Ende ist an den ersten Anschlussport (J1) angeschlossen ist;

und dass der zweite Anschlussport (J2) an die Masse angeschlossen ist.

**11.** Reflexionsverstärker, umfassend eine Impedanz-Anpassungsschaltung gemäß einem der voranstehenden Ansprüche, eine Polarisationsquelle (ST), die an das Versorgungsterminal (TA) angeschlossen ist, eine nicht lineare Impedanz (L), umfassend einen Supraleiter, wobei die genannte nicht lineare Impedanz (L) einen ersten Anschluss (B1) und einen zweiten Anschluss (B2) umfasst, wobei der erste Anschluss (B1) der Impedanz (L) an den ersten Port (J1) des Anschlusses der Anpassungsschaltung angeschlossen ist, wobei der zweite Anschluss (B2) der Impedanz (L) an den zweiten Port (J2) des Anschlusses der Anpassungsschaltung angeschlossen ist, der Verstärker, in dem die Spannung zwischen dem ersten Anschlussterminal (J1) und dem zweiten Anschlussterminal (J2) mittels der Spannungsquelle (ST) angeschlossen ist, derart ausgewählt ist, dass $f_p = \frac{2eV}{h}$ ist, wobei 2e die elektrische Ladung eines Cooper-Paares ist und h die Planck-Konstante ist.

**12.** Verstärker gemäß dem voranstehenden Anspruch, bei dem das SupraleiterMaterial der nicht linearen Impedanz (L) derart ausgewählt ist, dass $f_s < \frac{2\Delta}{h}$ ist, wobei $\Delta$ die Supraleiter-Gap des Superleiters ist.

**13.** Verstärker gemäß einem der zwei voranstehenden Ansprüche, bei dem die nicht lineare Impedanz (L) eine Josephson-Nahtstelle (JJ) umfasst.

**14.** Verstärker gemäß dem voranstehenden Anspruch, bei dem die Josephson-Nahtstelle vom Typ Supraleiter / Isolator / Supraleiter ist.

**15.** Verstärker gemäß einem der vier voranstehenden Ansprüche, bei dem die supraleitende nicht lineare Impedanz (L) ein SQUID umfasst.

**Claims**

**1.** Impedance matching circuit intended to be connected to a non-linear impedance (L) comprising a superconductor, said circuit comprising a first terminal designated first connection port (J1) intended to be connected to a first connector (B1) of the non-linear impedance (L), a second terminal designated second connection port (J2) intended to be connected to a second connector (B2) of the non-linear impedance (L), a third terminal designated input/output terminal (ES) intended to receive the signal to amplify with a gain in power G and a pass band BW and a fourth terminal designated supply terminal (TA) intended to be connected to a polarisation source (ST) and configured so that a voltage V is applied between the first connection port (J1) and the second connection port (J2), said circuit comprising a plurality of passive electrical components configured such that the impedance Z(f) between the first connection port (J1) and the second connection port (J2) for a signal of frequency f has a real part Re(Z(f)) such that:

- Re(Z($f_s$)) > 0 with $f_s$ a first frequency designated frequency of the signal to amplify;
- Re(Z($f_i$)) > 0 with $f_i$ a second frequency designated idler frequency;
- $Re(Z(0)) < \frac{h}{4e^2} \frac{f_p}{G.BW}$ with $f_p$ a third frequency designated pump frequency;
-

$$Re(Z(f_p + f_s)) < \frac{f_p + f_s}{f_i} Re(Z(f_i));$$

the pump frequency being chosen such that $nf_p = f_s + f_i$ with n an integer belonging to [1, +∞] and the idler frequency being chosen such that $f_i > \frac{k_B T}{h}$ with T the temperature of the circuit, $k_B$ Boltzmann's constant and h Planck's constant.

**2.** Circuit according to the preceding claim wherein $Re(Z(f_p + f_s)) < \frac{Re(Z(f_i))}{10}$.

**3.** Circuit according to one of the preceding claims wherein $Re(Z(0)) < \frac{h}{4e^2} \frac{1}{10G}$.

4.

Circuit according to one of the preceding claims wherein $\mathrm{Re}\,(Z(f_p)) < \frac{4e^2}{h}\,BW\,\frac{f_p}{f_s.f_i}\,\mathrm{Re}\big(Z(f_s)\big)\mathrm{Re}(Z(f_i))$.

5. Circuit according to one of the preceding claims wherein the input/output terminal (ES) is intended to be connected to an impedance of value $Z_0$ and $\mathrm{Re}\big(Z(f_s)\big) < 2\,\frac{|Z_{trans}(f_s)|^2}{Z_0}\,\mathrm{Re}(Z(f_s))$ with $Z_{trans}(f_s)$ the voltage at the level of the input/output terminal (ES) when a unit current of frequency $f_s$ is applied between the first connection port (J1) and the second connection port (J2).

6. Circuit according to one of the preceding claims wherein $\mathrm{Re}\,(Z(f_p + f_i)) < \frac{f_p + f_i}{f_s}\,\mathrm{Re}\big(Z(f_s)\big)$.

7. Circuit according to one of the preceding claims wherein $f_i > 4\,\frac{k_B T}{h}$.

8. Circuit according to one of the preceding claims wherein n = 1.

9. Circuit according to one of the preceding claims wherein $\max\big\{\mathrm{Re}\big(Z(f_s)\big), \mathrm{Re}\big(Z(f_i)\big)\big\} < \frac{h}{4e^2}$.

10. Circuit according to one of the preceding claims wherein the plurality of passive electrical components comprises:

   - a first waveguide segment ($T_1$) of which a first end is connected to the supply terminal (TA) through an inductance ($L_1$) and to the input/output terminal (ES) through a first capacitance ($C_1$) and a second end is connected to the first connection port (J1);
   - a second waveguide segment ($T_2$) of which a first end is connected to earth through a second capacitance ($C_2$) and a second end is connected to the first connection port (J1);
   - a third waveguide segment ($T_3$) of which a first end is connected to an infinite impedance and a second end is connected to the first connection port (J1);

   and in that the second connection port (J2) is connected to earth.

11. Reflection amplifier comprising an impedance matching circuit according to one of the preceding claims, a polarisation source (ST) connected to the supply terminal (TA), a non-linear impedance (L) comprising a superconductor, said non-linear impedance (L) comprising a first connector (B1) and a second connector (B2), the first connector (B1) of the impedance (L) being connected to the first connection port (J1) of the matching circuit, the second connector (B2) of the impedance (L) being connected to the second connection port (J2) of the matching circuit, said amplifier wherein the voltage applied between the first connection terminal (J1) and the second connection terminal (J2) by means of the voltage source (ST) is chosen such that $f_p = \frac{2eV}{h}$ with 2e the electric charge of a Cooper pair and h Planck's constant.

12. Amplifier according to the preceding claim wherein the superconductor material of the non-linear impedance (L) is chosen such that $f_s < \frac{2\Delta}{h}$ with $\Delta$ the superconductor gap of the superconductor.

13. Amplifier according to one of the two preceding claims wherein the non-linear impedance (L) comprises a Josephson junction.

14. Amplifier according to the preceding claim wherein the Josephson junction is of Superconductor/Insulator/Superconductor type.

15. Amplifier according to one of the four preceding claims wherein the non-linear superconducting impedance (L) comprises a SQUID.

Fig. 1

Fig. 2

Fig. 3

Fig. 4

Fig. 5

Fig. 6

Fig. 7

Fig. 8

Fig. 9

Fig. 10

## RÉFÉRENCES CITÉES DANS LA DESCRIPTION

**Documents brevets cités dans la description**

- WO 2012123642 A

**Littérature non-brevet citée dans la description**

- Tunable Impedance Matching for Josephson Junction Reflection Amplifier. **VERTERINEN et al.** IEEE TRANSACTION ON APPLIED SUPERCONDUCTIVITY. IEEE SERVICE CENTER, 01 Juin 2013, vol. 23

- **PASI LÄHTEEMÄKI et al.** Josephson junction microwave amplifier in self-organized noise compression mode. *SCIENTIFIC REPORT,* 20 Février 2012, vol. 2